# EUROPEAN PATENT SPECIFICATION

(11) **EP 4 253 138 B1**
(45) Date of publication and mention of the grant of the patent: **27.08.2025**
(21) Application number: 22895814.6
(22) Date of filing: 13.09.2022
(51) Int. Cl.: B60L 3/00, B60L 58/10, B60L 58/18, H02J 9/00, H02J 7/00, G06F 9/44

(54) **DEVICE FOR MANAGING BATTERY AND METHOD FOR CONTROLLING BATTERY**
VORRICHTUNG ZUR VERWALTUNG EINER BATTERIE UND VERFAHREN ZUR STEUERUNG EINER BATTERIE
DISPOSITIF DE GESTION DE BATTERIE ET PROCÉDÉ DE COMMANDE DE BATTERIE

(30) Priority: 16.11.2021 KR 20210157157
(43) Date of publication of application: 04.10.2023
(73) Proprietor: LG Energy Solution, Ltd., Seoul 07335 (KR)
(72) Inventor: NAM, Ho Chol, Daejeon 34122 (KR); KIM, Dong Hyun, Daejeon 34122 (KR); LEE, Seokjin, Daejeon 34122 (KR)
(74) Representative: Plasseraud IP
(86) International application number: PCT/KR2022/013597
(87) International publication number: WO 2023/090605

(56) References cited:
- CN-B- 102 998 625
- JP-A- 2003 323 235
- KR-A- 20210 053 103
- KR-B1- 101 621 407
- KR-B1- 101 621 407
- KR-B1- 101 967 464
- KR-B1- 102 007 835
- US-A- 6 055 643

## Description

### [Technical Field]

The present invention relates to a battery management apparatus and a battery control method and, more particularly, to a battery management apparatus capable of quickly responding to a request from an upper system and a battery control method thereof.

### [Background Art]

Secondary batteries are batteries that can be recharged and reused repeatedly. Secondary batteries are typically manufactured as a battery module or a battery pack formed by connecting a plurality of battery cells in series according to an output capacity required by a device to be used as power supply sources for various devices. Such batteries are being used in various fields ranging from small high-tech electronic devices such as smart phones to electric bicycles, electric vehicles, and energy storage systems (ESS).

A battery module or battery pack is a structure in which a plurality of battery cells are combined. When overvoltage, overcurrent, or overheating occurs in some battery cells, a problem occurs in safety and operating efficiency of the entire battery module or battery pack. Thus, a means for detecting these problems is essential. Accordingly, a battery module or battery pack is equipped with a battery management system (BMS) that measures a voltage value of each battery cell and monitors and controls a voltage state of the battery cells based on measured values.

The battery management system manages battery states, such as a normal state, a low power state, and a shutdown state. The battery management system makes transitions of the battery state according to a request from an upper system (e.g., a vehicle). Here, when the battery management system receives a re-request for use during an operation of switching to a low-power state which was initiated because no request for battery use had been received from the upper system, it takes a considerable amount of time to finish the ongoing switching operation and to return to a normal state. Accordingly, a problem arises that a normal response to the request from the upper system is impossible during a corresponding time period.

Embodiments and examples from the prior art are presented in the documents KR102007835B1 and US6055643A.

### [Summary of Invention]

The invention is defined by the appended independent claims. Dependent claims constitute embodiments of the invention.

### [Technical Problem]

To obviate one or more problems described above, an object of the present disclosure is to provide an apparatus for managing a battery system.

To obviate one or more problems described above, another object of the present disclosure is to provide a battery control method.

### [Technical Solution]

In order to achieve the objective of the present disclosure, an apparatus for managing a battery system may comprise: at least one processor; and a memory configured to store at least one instruction executed by the at least one processor, wherein the at least one instruction includes: an instruction to perform a procedure for switching a state of at least one battery pack to a sleep mode which is a low power state, in response to no request for use of the battery system having been received from an upper system for a predetermined period of time; an instruction to exit the procedure for switching to the sleep mode, in response to a request for activating the battery system that is received from the upper system during performing a plurality of operations included in the procedure for switching to the sleep mode; and an instruction to switch the state of the at least one battery pack to a normal state.

The procedure for switching the state of at least one battery pack to a sleep mode may include a procedure for checking whether a request for activating the battery system is generated from the upper system whenever each operation included in the procedure for switching to the sleep mode is performed.

The procedure for checking whether the request for activating the battery system is generated may include, for an operation that takes more than a threshold period of time among a plurality of operations included in the procedure for switching to the sleep mode, checking a plurality of times whether a request for activating the battery system is generated while the corresponding operation is being performed.

The instruction to exit the procedure for switching to the sleep mode may include an instruction to perform one or more rollback operations corresponding to one or more operations previously performed during the procedure for switching to the sleep mode in a reverse order to those of the one or more operations previously performed during the procedure for switching to the sleep mode.

The upper system may be a vehicle body.

A first operation included in the procedure for switching to the sleep mode may be an operation for terminating a device or controlling the device to a sleep or OFF state, wherein the device is included in the battery management apparatus, and a rollback operation for the first operation may be an operation of starting the device to run or operation of controlling the device to a normal or ON state.

According to another embodiment of the present disclosure, a method for controlling a battery system by a battery management system, the method may comprise: performing a procedure for switching a state of at least one battery pack to a sleep mode which is a low power state, in response to no request for use of the battery system having been received from an upper system for a predetermined period of time; exiting the procedure for switching to the sleep mode, in response to a request for activating the battery system that is received from the upper system during performing a plurality of operations included in the procedure for switching to the sleep mode; and switching the state of the at least one battery pack to a normal state.

The procedure for switching the state of at least one battery pack to a sleep mode may include a procedure for checking whether a request for activating the battery system is generated from the upper system whenever each operation included in the procedure for switching to the sleep mode is performed.

The procedure for checking whether the request for activating the battery system is generated may include, for an operation that takes more than a threshold period of time among a plurality of operations included in the procedure for switching to the sleep mode, checking a plurality of times whether a request for activating the battery system is generated while the corresponding operation is being performed.

The exiting the procedure for switching to the sleep mode may include performing one or more rollback operations corresponding to one or more operations previously performed during the procedure for switching to the sleep mode in a reverse order to those of the one or more operations previously performed during the procedure for switching to the sleep mode.

The upper system may be a vehicle body.

A first operation included in the procedure for switching to the sleep mode may be an operation for terminating a device or controlling the device to a sleep or OFF state, wherein the device is included in the battery management apparatus, and a rollback operation for the first operation may be an operation of starting the device to run or operation of controlling the device to a normal or ON state.

### [Advantageous Effects]

According to embodiments of the present disclosure, processing delay time required to return to a normal state for a battery activation request generated while a battery pack transitions to a low power state can be minimized.

### [Brief Description of the Drawings]

FIG. 1 shows a structure of a battery system to which the present invention may be applied.
FIG. 2 is a diagram illustrating an example of states of a battery system and state transitions of the battery system.
FIG. 3 shows a table of an operational flowchart of the BMS in a sleep mode procedure according to a typical battery control method.
FIG. 4 is an operational flowchart related to a sleep mode entry procedure in a battery control method according to embodiments of the present invention.
FIG. 5 is a number diagram illustrating an operational sequence of a sleep mode entry and exit procedure in a battery control method according to embodiments of the present invention.
FIG. 6 is a operational flowchart of a battery control method according to embodiments of the present invention.

### [Detailed Description]

As the present invention may be susceptible to various modifications and alternative forms, specific embodiments thereof are shown by way of example in the drawings and will herein be described in detail. It should be understood, however, that there is no intent to limit the invention to the particular forms disclosed, but on the contrary, the invention is to cover all modifications, equivalents, and alternatives falling within the spirit and scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (i.e., "between" versus "directly between," "adjacent" versus "directly adjacent," etc.).

The terminology used herein is for the purpose of describing particular embodiments only and is not intended to be limiting of the invention. As used herein, the singular forms "a," "an," and "the" are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, example embodiments of the present invention will be described in detail with reference to the accompanying drawings.

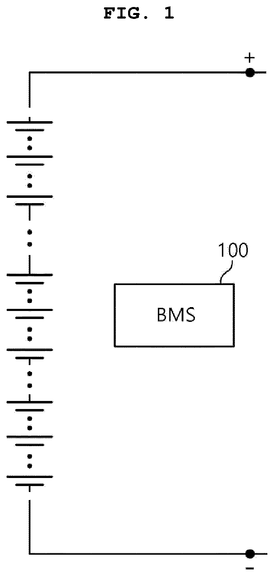

FIG. 1 shows a structure of a battery system to which the present invention may be applied.

In FIG. 1, a battery pack or battery module may include a plurality of battery cells connected in series. The battery pack or module may be connected to a load through a positive terminal and a negative terminal to perform charging or discharging. The most commonly used battery cell is a lithium-ion (Li-Ion) battery cell.

A battery management system (BMS) 100 may be installed in a battery module or battery pack. The BMS may monitor a current, a voltage and a temperature of each battery pack to be managed, calculate a state of charge (SOC) of the battery based on monitoring results to control charging and discharging. Here, the State of Charge (SOC) refers to a current state of charge of a battery, represented in percent points [%], and the State of Health (SOH) may be a current condition of a battery comprated to its ideal conditions, represented in percent points [%].

The BMS may monitor battery cells, read cell voltages, and transmit them to other systems connected to the battery. The BMS also balances charges of the battery cells equally to prolong a life of the battery system.

The BMS 100 may include various components such as a fuse, a current sensing element, a thermistor, a switch, and a balancer to perform such operations. In most cases, a micro controller unit (MCU) 110 or a battery monitoring integrated chip (BMIC) for interworking and controlling these components is additionally included in the BMS. Here, the BMIC may be located inside the BMS and may be an integrated circuit (IC) type component that measures information such as voltage, temperature, and current of a battery cell/module.

Furthermore, the battery management system monitors battery cells, reads cell voltages and passes them on to other systems connected to the battery. For this, the BMS includes a communication module 120 for communicating with other systems in a device including the battery system. The communication module of the BMS can communicate with other systems in the device using CAN (Controller Area Network). Here, components, modules or systems in the BMS are connected to each other through a CAN bus.

Controller Area Network (CAN) is a communication standard designed for microcontrollers or devices to communicate with each other in a vehicle without a host computer. The CAN communication is a non-host bus type message-based network protocol mainly used for communication between controllers, and is mainly used in vehicles.e

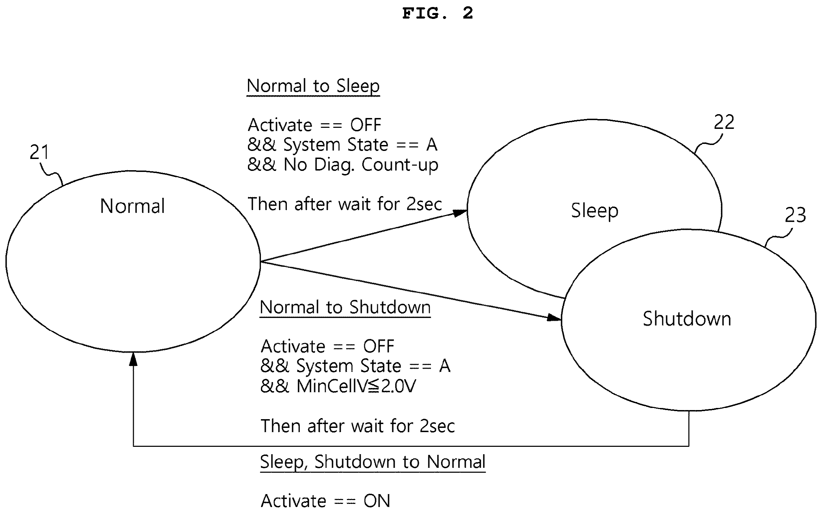

FIG. 2 is a diagram illustrating an example of states of a battery system and state transitions of the battery system.

The battery management system may manage a battery state as a normal mode, a sleep mode, or a shutdown mode. The normal mode 21 may be a typical operation mode of a battery pack in which the battery pack performs charging or discharging. The sleep mode 22 may indicate a case in which a battery pack is on standby in a low power state. Furthermore, the shutdown mode 23 may indicate a case in which the operation of the battery pack is stopped.

According to the example shown in FIG. 2, a transition from a normal mode to a sleep mode may occur if the battery system is off (e.g., in a case of a vehicle, an engine is turned off), a system state is a default (A), any other abnormalities in the system do not occur (No Diag. Count-up), and after waiting time of 2 seconds has elapsed. Furthermore, a transition from a normal mode to a shutdown mode may occur after a standby time of 2 seconds has elapsed when the battery system is off, the system state is default (A), and a minimum cell voltage (MinCellV) has fallen below a threshold. Meanwhile, a transition from the sleep mode or the shutdown mode to the normal mode may occur when the battery system is turned on (e.g., when the ignition of the vehicle is turned on).

Here, if there is a re-request for battery use from an upper system during an operation of switching to the sleep mode due to no request from the upper system, the BMS finishes previously ongoing switching procedure and return to a normal state, which takes considerable amount of time.

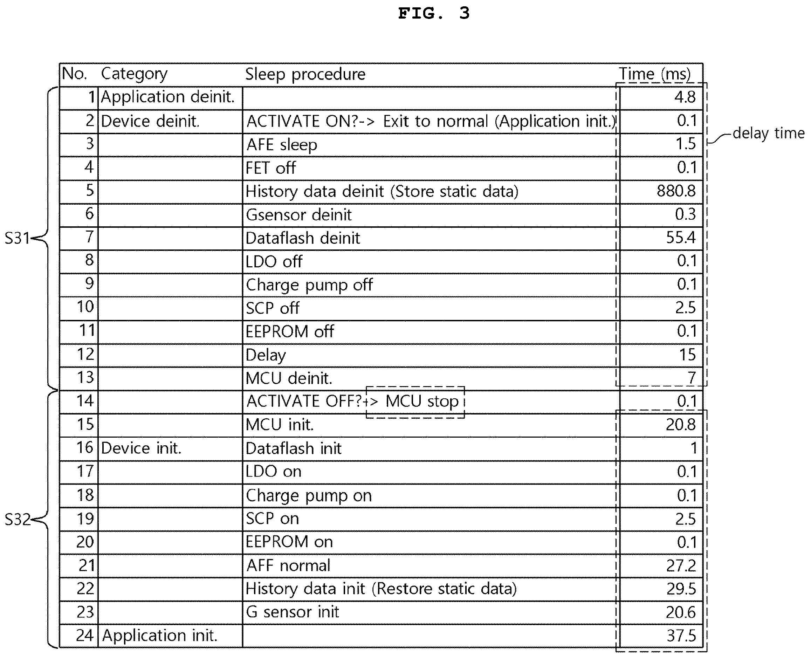

FIG. 3 shows a table of an operational flowchart of the BMS in a sleep mode procedure according to a typical battery control method.

The table in FIG. 3 shows step-by-step program codes executed by a controller or processor (for example, a micro controller unit (MCU)) of the BMS when the battery enters a sleep mode. Each device in the BMS performs operations corresponding to each program code or command under control of the MCU.

Referring to FIG. 3, in a sleep mode entry procedure, a battery management application is deinitialized (Application deinit.) and a device deinitialization procedure (device deinit.) is performed (S31). In the device deinitialization procedure, it is checked whether the battery system is ON state, and when battery system is ON, a transition procedure to a normal state, i.e., an application initialization procedure is performed. On the contrary, when the battery system is off, an operation deinitialization procedure for devices or components in the BMS are performed.

The operation deinitialization procedure for devices or components in the BMS may include an analog front-end (AFE) sleep, an field effect transistor (FET) off, a history data deinitialization (store data), a sensor deinitialization, a dataflash off, a LDO (Linear & low-dropout) off, a charge pump off, a SCP (Self Control Protector) off, and an EEPROM (Electrically Erasable PROM) off, and an MCU deinitialization in the last step. In the table of Fig. 3, time required for finishing operations of each device is indicated to the right of each operation item.

On the other hand, an operation initialization procedure (S32) of the BMS according to a battery activate request may be performed in a reverse order to the operation deinitialization procedure, wherein the operation initialization procedure starts with an MCU initialization, followed by a dataflash on, a LDO on, a charge pump on, a SCP on, an EEPROM ON, an AFE normal, a history data initialization, and a sensor initialization.

However, even when a re-request for battery use, that is, a request for battery activation (eg, Ignition on or Activate on in a case of a vehicle) occurs while the BMS performs a procedure for entering the sleep mode, the device deinitializaiton procedure in the table of FIG. 3 is not interrupted and all internal operations in the device deinitializaiton procedure are performed until the procedure is completed. Thus, when a battery activation request occurs while the BMS is performing a sleep mode entry procedure, it is possible to escape from the sleep mode entry procedure only after completing the ongoing sleep mode entry procedure. Here, the delay time in between may reach a maximum of about 940 ms.

Here, for an electric vehicle that requires a quick response, an impact of such a delay on a system performance may be significant in that the electric vehicle is required to be able to respond to a request within a few hundred ms after activate ON.

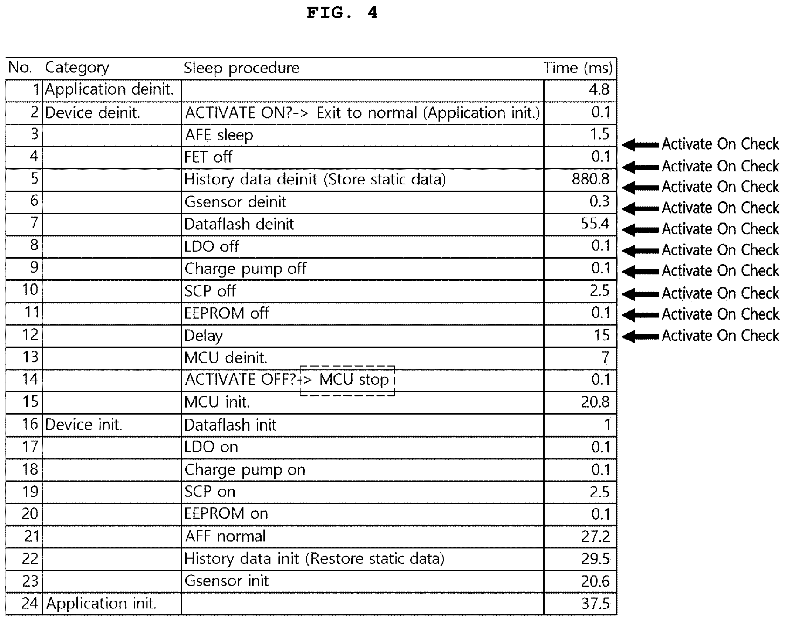

FIG. 4 is an operational flowchart related to a sleep mode entry procedure in a battery control method according to embodiments of the present invention.

According to embodiments of the present invention, the BMS records operations in the sleep mode entry process and the sleep mode exit process as shown in FIG. 4. Here, an Activate On Check is performed for each operation step in the sleep mode entry process. In other words, the activation on check is performed whenever each step such as AFE sleep, FET off, history data deinitialization, sensor deinitialization, dataflash off, LDO off, charge pump off, SCP off, or EEPROM off is performed.

Furthermore, for an operation having a long execution time, such as a history data deinitialization and a dataflash deinitialization, the Activate-On check may be performed during the corresponding operation, and the Activate-On check during the corresponding operation may be performed multiple times. In other words, for an operation that takes more than a threshold time among a plurality of operations included in the procedure for switching to the sleep mode, the Activate-On check (whether a battery system activation request is generated) may be performed a plurality of times while the corresponding operation is being performed.

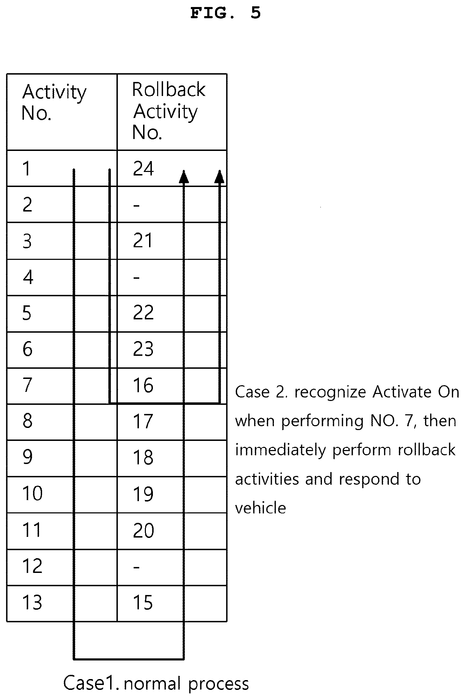

FIG. 5 is a number diagram illustrating an operational sequence of a sleep mode entry and exit procedure in a battery control method according to embodiments of the present invention.

In the diagram of FIG. 5 according to embodiments of the present invention, each operation included in the procesure is represented by a number. The activity number (Activity No.) indicates an operation number in a sleep mode entry procedure. In addition, the rollback activity No. indicates an rollback activity number in a sleep mode exit procedure. Here, each rollback activity number is positioned to be associated with a corresponding activity number.

For example, activity number 1 in FIG. 5 indicates an application deinitialization operation, and a corresponding rollback activity is an application initialization operation and may be represented by number 24.

FIG. 5 shows two instances including an instance that there is no battery activation request in the process of entering the sleep mode by the BMS (case 1) and an instance that the battery activation request occurs at a point of performing activity 7 during the process of entering the sleep mode by the BMS (case 2).

If no battery activation is requested during a process of entering the sleep mode, the BMS performs all operations in the sleep mode entry procedure and then, if necessary, sequentially performs all operations in the sleep mode exit procedure corresponding thereto.

On the other hand, if a battery activation request occurs at the point of performing activity 7 while the BMS enters a sleep mode, then activity 16 is performed as the next operation. Here, activities 8 to 13 and corresponding rollback activities (activities 15 to 17) are not performed. Referring to FIG. 4, operation 7 is a dataflash deinitialization operation, and operation 16 is a dataflash initialization operation. Thereafter, the BMS sequentially performs activities 23, 22, 21, and 24.

In other words, one or more rollback operation corresponding to one or more previously performed operations are performed in a reverse order to that of one or more previously performed operations during the procedure for switching to the sleep mode.

In summary, when a battery activation request occurs during a sleep mode entry process, the BMS according to the present invention may perform at least one rollback operation corresponding to previously performed operations in the sleep mode entry process, thereby switching to a normal state and immediately responding to a request from the upper system.

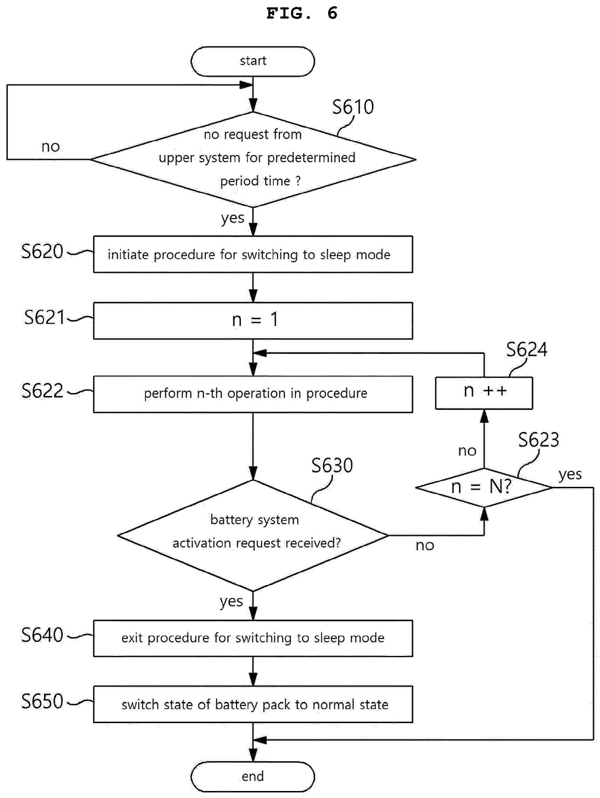

FIG. 6 is a operational flowchart of a battery control method according to embodiments of the present invention.

The battery control method according to embodiments of the present invention may be performed by a controller in the BMS, for example, an MCU, but the operating subject of the method according to the present invention is not limited thereto.

The controller (MCU) may check whether a request for use of the battery system has not been received from the upper system for a predetermined period of time (S610). When there is no request for battery use for a certain period of time, the controller may start a procedure for switching a state of the battery pack to a sleep mode which is a low power state (S620).

Here, whenever each operation included in the procedure for switching to the sleep mode is performed (S621, S622, S623, S624), it is checked whether a battery system activation request has occurred from the upper system (S630).

Here, a procedure for checking whether the request for activating the battery system is generated may include, for an operation that takes more than a threshold period of time among a plurality of operations included in the procedure for switching to the sleep mode, checking a plurality of times whether a request for activating the battery system is generated while the corresponding operation is being performed.

If a battery system activation request is received from the upper system while performing a plurality of operations included in the procedure for switching to the sleep mode (Yes in S630), in response to the request, the procedure for switching to the sleep mode may be exited (S640). The process of exiting the procedure of switching to the sleep mode may be performed by executing one or more rollback operations corresponding to one or more operations previously performed during the procedure of switching to the sleep mode. Here, the rollback operations may be performed in a reverse order to that of one or more operations that have already been performed.

Thereafter, the controller may change the state of the battery pack to a normal state (S650).

On the other hand, when any activation request for the battery system is not received during the sleep mode switching procedure and all operations in the sleep mode switching procedure are completed (Yes in S624), the procedure is terminated. In FIG. 6, N is a total number of operations included in the sleep mode switching procedure.

The embodiments of the present disclosure may be implemented as program instructions executable by a variety of computers and recorded on a computer readable medium. The computer readable medium may include a program instruction, a data file, a data structure, or a combination thereof. The program instructions recorded on the computer readable medium may be designed and configured specifically for the present disclosure or can be publicly known and available to those who are skilled in the field of computer software.

Some aspects of the present invention have been described above in the context of a device but may be described using a method corresponding thereto. Here, blocks or the device corresponds to operations of the method or characteristics of the operations of the method. Similarly, aspects of the present invention described above in the context of a method may be described using blocks or items corresponding thereto or characteristics of a device corresponding thereto. Some or all of the operations of the method may be performed, for example, by (or using) a hardware device such as a microprocessor, a programmable computer or an electronic circuit. In some embodiments, one or more of most important operations of the method may be performed by such a device.

While the example embodiments of the present invention and their advantages have been described in detail, it should be understood that various changes, substitutions and alterations may be made herein without departing from the scope of the invention.

## Claims

1. An apparatus for managing a battery system (100), the apparatus comprising:
at least one processor; and
a memory configured to store at least one instruction executed by the at least one processor,
wherein the at least one instruction includes:
an instruction to perform a procedure (S620) for switching a state of at least one battery pack of the battery system to a sleep mode which is a low power state, in response to no request for use of the battery system having been received from an upper system for a predetermined period of time;
an instruction to exit the procedure (S640) for switching to the sleep mode, in response to a request for activating the battery system that is received from the upper system during performing a plurality of operations included in the procedure for switching to the sleep mode (22); and
an instruction to switch (S650) the state of the at least one battery pack to a normal state (21),
wherein the procedure for switching the state of at least one battery pack to the sleep mode includes;
a procedure for checking whether a request for activating the battery system is generated from the upper system whenever each operation among the plurality of operations included in the procedure for switching to the sleep mode is performed.

2. The apparatus of claim 1, wherein the procedure for checking whether the request for activating the battery system is generated includes;
for an operation that takes more than a threshold period of time among the plurality of operations included in the procedure for switching to the sleep mode, checking a plurality of times whether the request for activating the battery system is generated while the corresponding operation is being performed.

3. The apparatus of claim 1, wherein the instruction to exit the procedure for switching to the sleep mode includes;
an instruction to perform one or more rollback operations corresponding to one or more of the plurality of operations previously performed during the procedure for switching to the sleep mode in a reverse order of the one or more of the plurality of operations previously performed during the procedure for switching to the sleep mode.

4. The apparatus of claim 1, wherein the upper system includes a vehicle body.

5. The apparatus of claim 1, wherein a first operation among the plurality of operations included in the procedure for switching to the sleep mode is an operation for terminating a device or controlling the device to a sleep or OFF state, and wherein the device is included in apparatus for managing the battery system, and a rollback operation for the first operation is an operation of starting the device to run or operation of controlling the device to a normal or ON state.

6. A method for controlling a battery system in a battery management system, the method comprising:
Performing (S620) a procedure for switching a state of at least one battery pack in the battery system to a sleep mode which is a low power state, in response to no request for use of the battery system having been received from an upper system for a predetermined period of time;
exiting (S640) the procedure for switching to the sleep mode, in response to a request for activating the battery system that is received from the upper system during performing a plurality of operations included in the procedure for switching to the sleep mode; and
switching (S650) the state of the at least one battery pack to a normal state, wherein the procedure for switching the state of at least one battery pack to the sleep mode includes;
a procedure for checking whether a request for activating the battery system is generated from the upper system whenever each operation among the plurality of operations included in the procedure for switching to the sleep mode is performed.

7. The method of claim 6, wherein the procedure for switching the state of at least one battery pack to the sleep mode includes;
a procedure for checking whether a request for activating the battery system is generated from the upper system whenever each operation among the plurality of operations included in the procedure for switching to the sleep mode is performed.

8. The method of claim 7, wherein the procedure for checking whether the request for activating the battery system is generated includes;
for an operation that takes more than a threshold period of time among the plurality of operations included in the procedure for switching to the sleep mode, checking a plurality of times whether the request for activating the battery system is generated while the corresponding operation is being performed.

9. The method of claim 6, wherein the exiting of the procedure for switching to the sleep mode includes;
performing one or more rollback operations corresponding to one or more of the plurality of operations previously performed during the procedure for switching to the sleep mode in a reverse order of the one or more of the plurality of operations previously performed during the procedure for switching to the sleep mode.

10. The method of claim 6, wherein the upper system includes a vehicle body.

11. The method of claim 6, wherein a first operation among the plurality of operations included in the procedure for switching to the sleep mode is an operation for terminating a device or controlling the device to a sleep or OFF state, and
wherein the device is included in the battery management apparatus, and a rollback operation for the first operation is an operation of starting the device to run or operation of controlling the device to a normal or ON state.

## Patentansprüche

1. Vorrichtung zum Verwalten eines Batteriesystems (100), wobei die Vorrichtung umfasst:
wenigstens einen Prozessor; und
einen Speicher, welcher dazu eingerichtet ist, wenigstens eine Anweisung zu speichern, welche von dem wenigstens einen Prozessor ausgeführt wird,
wobei die wenigstens eine Anweisung umfasst:
eine Anweisung zum Durchführen eines Vorgangs (S620) zum Wechseln eines Zustands wenigstens eines Batteriepacks des Batteriesystems in einen Schlafmodus, welcher ein Niedrigenergie-Zustand ist, als Reaktion auf ein Nichtempfangen einer Nutzungsanfrage des Batteriesystems von einem höheren System für einen vorbestimmten Zeitraum;
eine Anweisung zum Beenden des Vorgangs (S640) zum Wechseln in den Schlafmodus als Reaktion auf eine Anfrage zum Aktivieren des Batteriesystems, welche während eines Durchführens einer Mehrzahl von Betrieben, welche in dem Vorgang zum Wechseln in den Schlafmodus (22) umfasst sind, von dem höheren System empfangen wird; und
eine Anweisung zum Wechseln (S650) des Zustands des wenigstens einen Batteriepacks in einen normalen Zustand (21),
wobei der Vorgang zum Wechseln des Zustands wenigstens eines Batteriepacks in den Schlafmodus umfasst:
einen Vorgang zum Überprüfen, ob eine Anfrage zum Aktivieren des Batteriesystems von dem höheren System erzeugt wird, jedes Mal wenn jeder Betrieb unter der Mehrzahl von Betrieben durchgeführt wird, welche in dem Vorgang zum Wechseln in den Schlafmodus umfasst sind.

2. Vorrichtung nach Anspruch 1, wobei der Vorgang zum Überprüfen, ob die Anfrage zum Aktivieren des Batteriesystems erzeugt wird, umfasst:
für einen Betrieb, welcher unter der Mehrzahl von Betrieben, welche in dem Vorgang zum Wechseln in den Schlafmodus umfasst sind, länger als eine Schwellenwert-Zeitdauer andauert, Überprüfen einer Mehrzahl von Malen, ob die Anfrage zum Aktivieren des Batteriesystems erzeugt wird, während der entsprechende Betrieb durchgeführt wird.

3. Vorrichtung nach Anspruch 1, wobei die Anweisung zum Beenden des Vorgangs zum Wechseln in den Schlafmodus umfasst:
eine Anweisung zum Durchführen eines oder mehrerer Rollback-Betriebe, welche einem oder mehreren der Mehrzahl von Betrieben entsprechen, welche zuvor während des Vorgangs zum Wechseln in den Schlafmodus durchgeführt worden sind, in umgekehrter Reihenfolge des einen oder der mehreren aus der Mehrzahl von Betrieben, welche zuvor während des Vorgangs zum Wechseln in den Schlafmodus durchgeführt worden sind.

4. Vorrichtung nach Anspruch 1, wobei das höhere System einen Fahrzeugkörper umfasst.

5. Vorrichtung nach Anspruch 1, wobei ein erster Betrieb unter der Mehrzahl von Betrieben, welche in dem Vorgang zum Wechseln in den Schlafmodus umfasst sind, ein Betrieb zum Abbrechen einer Vorrichtung oder Steuern der Vorrichtung in einen Schlaf- oder Aus-Zustand ist, und wobei die Vorrichtung in einer Vorrichtung zum Verwalten des Batteriesystems umfasst ist, und wobei ein Rollback-Betrieb für den ersten Betrieb ein Betrieb eines Startens der Vorrichtung zum Hochfahren ist oder ein Betrieb eines Steuerns der Vorrichtung in einem normalen oder An-Zustand ist.

6. Verfahren zum Steuern eines Batteriesystems in einem Batterieverwaltungssystem, wobei das Verfahren umfasst:
Durchführen (S620) eines Vorgangs zum Wechseln eines Zustands wenigstens eines Batteriepacks in dem Batteriesystem in einen Schlafmodus, welcher ein Niedrigenergie-Zustand ist, als Reaktion auf ein Nichtempfangen einer Nutzungsanfrage des Batteriesystems von einem höheren System für einen vorbestimmten Zeitraum;
Beenden (S640) des Vorgangs zum Wechseln in den Schlafmodus als Reaktion auf eine Anfrage zum Aktivieren des Batteriesystems, welche während eines Durchführens einer Mehrzahl von Betrieben, welche in dem Vorgang zum Wechseln in den Schlafmodus umfasst sind, von dem höheren System empfangen wird, und
Wechseln (S650) des Zustands des wenigstens einen Batteriepacks in einen normalen Zustand (21), wobei der Vorgang zum Wechseln des Zustands wenigstens eines Batteriepacks in den Schlafmodus umfasst:
einen Vorgang zum Überprüfen, ob eine Anfrage zum Aktivieren des Batteriesystems von dem höheren System erzeugt wird, jedes Mal wenn jeder Betrieb unter der Mehrzahl von Betrieben durchgeführt wird, welche in dem Vorgang zum Wechseln in den Schlafmodus umfasst sind.

7. Verfahren nach Anspruch 6, wobei der Vorgang zum Wechseln des Zustands wenigstens eines Batteriepacks in den Schlafmodus umfasst:
einen Vorgang zum Überprüfen, ob eine Anfrage zum Aktivieren des Batteriesystems von dem höheren System erzeugt wird, jedes Mal wenn jeder Betrieb unter der Mehrzahl von Betrieben durchgeführt wird, welche in dem Vorgang zum Wechseln in den Schlafmodus umfasst sind.

8. Verfahren nach Anspruch 7, wobei der Vorgang zum Überprüfen, ob die Anfrage zum Aktivieren des Batteriesystems erzeugt wird, umfasst:
für einen Betrieb, welcher unter der Mehrzahl von Betrieben, welche in dem Vorgang zum Wechseln in den Schlafmodus umfasst sind, länger als eine Schwellenwert-Zeitdauer andauert, Überprüfen einer Mehrzahl von Malen, ob die Anfrage zum Aktivieren des Batteriesystems erzeugt wird, während der entsprechende Betrieb durchgeführt wird.

9. Verfahren nach Anspruch 6, wobei das Beenden des Vorgangs zum Wechseln in den Schlafmodus umfasst:
Durchführen eines oder mehrerer Rollback-Betriebe, welche einem oder mehreren der Mehrzahl von Betrieben entsprechen, welche zuvor während des Vorgangs zum Wechseln in den Schlafmodus durchgeführt worden sind, in einer umgekehrten Reihenfolge des einen oder der mehreren aus der Mehrzahl von Betrieben, welche zuvor während des Vorgangs zum Wechseln in den Schlafmodus durchgeführt worden sind.

10. Verfahren nach Anspruch 6, wobei das höhere System einen Fahrzeugkörper umfasst.

11. Verfahren nach Anspruch 6, wobei ein erster Betrieb unter der Mehrzahl von Betrieben, welche in dem Vorgang zum Wechseln in den Schlafmodus umfasst sind, ein Betrieb zum Abbrechen einer Vorrichtung oder Steuern der Vorrichtung in einen Schlaf- oder Aus-Zustand ist, und
wobei die Vorrichtung in der Batterieverwaltungsvorrichtung umfasst ist, und wobei ein Rollback-Betrieb für den ersten Betrieb ein Betrieb eines Startens der Vorrichtung zum Hochfahren ist oder ein Betrieb eines Steuerns der Vorrichtung in einem normalen oder An-Zustand ist.

## Revendications

1. Appareil de gestion d'un système de batterie (100), l'appareil comprenant :
au moins un processeur ; et
une mémoire configurée pour stocker au moins une instruction exécutée par l'au moins un processeur,
dans lequel ladite au moins une instruction comporte :
une instruction de réalisation d'une procédure (S620) de passage d'un état d'au moins un bloc-batterie du système de batterie à un mode veille qui est un état de faible consommation, en réponse à la non-réception d'une demande d'utilisation du système de batterie en provenance d'un système supérieur pendant une période de temps prédéterminée ;
une instruction de sortie de la procédure (S640) de passage en mode veille, en réponse à la réception d'une demande d'activation du système de batterie en provenance du système supérieur lors de la réalisation d'une pluralité d'opérations incluses dans la procédure de passage en mode veille (22) ; et
une instruction de passage (S650) de l'état de l'au moins un bloc-batterie à un état normal (21),
dans lequel la procédure de passage de l'état d'au moins un bloc-batterie en mode veille comporte ;
une procédure de vérification de la génération d'une demande d'activation du système de batterie à partir du système supérieur chaque fois que chaque opération parmi la pluralité d'opérations incluses dans la procédure de passage en mode veille est réalisée.

2. Appareil selon la revendication 1, dans lequel la procédure de vérification de la génération de la demande d'activation du système de batterie comporte :
pour une opération qui prend plus d'une période de seuil parmi la pluralité d'opérations incluses dans la procédure de passage en mode veille, la vérification à plusieurs reprises de la génération de la demande d'activation du système de batterie pendant la réalisation de l'opération correspondante.

3. Appareil selon la revendication 1, dans lequel l'instruction de sortie de la procédure de passage en mode veille comporte ;
une instruction de réalisation d'une ou plusieurs opérations de retour en arrière correspondant à une ou plusieurs de la pluralité d'opérations précédemment réalisées pendant la procédure de passage en mode veille dans un ordre inverse des une ou plusieurs de la pluralité d'opérations précédemment réalisées pendant la procédure de passage en mode veille.

4. Appareil selon la revendication 1, dans lequel le système supérieur comporte une carrosserie de véhicule.

5. Appareil selon la revendication 1, dans lequel une première opération parmi la pluralité d'opérations incluses dans la procédure de passage en mode veille est une opération d'interruption d'un dispositif ou de commande du dispositif à un état de veille ou d'ARRÊT, et dans lequel le dispositif est inclus dans un appareil de gestion du système de batterie, et une opération de retour en arrière pour la première opération est une opération de démarrage du fonctionnement du dispositif ou une opération de commande du dispositif à un état normal ou d'ARRÊT.

6. Procédé de commande d'un système de batterie dans un système de gestion de batterie, le procédé comprenant :
la réalisation (S620) d'une procédure de passage d'un état d'au moins un bloc-batterie dans le système de batterie à un mode veille qui est un état de faible consommation,
en réponse à la non-réception d'une demande d'utilisation du système de batterie en provenance d'un système supérieur pendant une période de temps prédéterminée ;
la sortie (S640) de la procédure de passage en mode veille, en réponse à la réception d'une demande d'activation du système de batterie en provenance du système supérieur lors de la réalisation d'une pluralité d'opérations incluses dans la procédure de passage en mode veille ; et
le passage (S650) de l'état de l'au moins un bloc-batterie à un état normal, dans lequel la procédure de passage de l'état d'au moins un bloc-batterie en mode veille comporte ;
une procédure de vérification de la génération d'une demande d'activation du système de batterie à partir du système supérieur chaque fois que chaque opération parmi la pluralité d'opérations incluses dans la procédure de passage en mode veille est réalisée.

7. Procédé selon la revendication 6, dans lequel la procédure de passage de l'état d'au moins un bloc-batterie en mode veille comporte ;
une procédure de vérification de la génération d'une demande d'activation du système de batterie à partir du système supérieur chaque fois que chaque opération parmi la pluralité d'opérations incluses dans la procédure de passage en mode veille est réalisée.

8. Procédé selon la revendication 7, dans lequel la procédure de vérification de la génération de la demande d'activation du système de batterie comporte :
pour une opération qui prend plus d'une période de seuil parmi la pluralité d'opérations incluses dans la procédure de passage en mode veille, la vérification à plusieurs reprises de la génération de la demande d'activation du système de batterie pendant la réalisation de l'opération correspondante.

9. Procédé selon la revendication 6, dans lequel la sortie de la procédure de passage en mode veille comporte ;
la réalisation d'une ou plusieurs opérations de retour en arrière correspondant à une ou plusieurs de la pluralité d'opérations précédemment réalisées pendant la procédure de passage en mode veille dans un ordre inverse des une ou plusieurs de la pluralité d'opérations précédemment réalisées pendant la procédure de passage en mode veille.

10. Procédé selon la revendication 6, dans lequel le système supérieur comporte une carrosserie de véhicule.

11. Procédé selon la revendication 6, dans lequel une première opération parmi la pluralité d'opérations incluses dans la procédure de passage en mode veille est une opération d'interruption d'un dispositif ou de commande du dispositif à un état de veille ou d'ARRÊT, et
dans lequel le dispositif est inclus dans l'appareil de gestion de batterie, et une opération de retour en arrière pour la première opération est une opération de démarrage du fonctionnement du dispositif ou une opération de commande du dispositif à un état normal ou de MARCHE.
